# EUROPEAN PATENT SPECIFICATION

(11) **EP 2 122 475 B1**
(45) Date of publication and mention of the grant of the patent: **28.11.2012**
(21) Application number: 08708803.5
(22) Date of filing: 07.02.2008
(51) Int. Cl.: G06F 13/40

(54) **DATA TRANSFER CIRCUIT**
DATENTRANSFERSCHALTUNG
CIRCUIT DE TRANSFERT DE DONNÉES

(30) Priority: 09.02.2007 GB 0702571
(43) Date of publication of application: 25.11.2009
(73) Proprietor: TEXAS INSTRUMENTS LIMITED, Northampton Business Park, Northampton NN4 7YL (GB)
(72) Inventor: BATTY, Sean, Bedfordshire MK43 0GW (GB)
(74) Representative: Holt, Michael
(86) International application number: PCT/EP2008/051525
(87) International publication number: WO 2008/095991

(56) References cited:
- SANJAY KASTURIA, MEMBER, IEEE, AND JACK H. WINTERS, SENIOR MEMBER. IEEE: "Techniques for High-speed Implementation of Nonlinear Cancellation" IEEE JOURNAL ON SELECTED AREAS IN COMMUNICATIONS. VOL. 9. NO. 5. JUNE 1991, [Online] vol. 9, no. 5, 5 June 1991 (1991-06-05), pages 711-717, XP002484179 Retrieved from the Internet: URL:http://ieeexplore.ieee.org/iel1/49/285 5/00087640.pdf?tp=&isnumber=&arnumber=8764 0> [retrieved on 2008-06-11]
- MIKE HARWOOD, NIRMAL WARKE, RICHARD SIMPSON, TOM LESLIE, AJITH AMERASEKERA, SEAN BATTY, CAESAR.WONT.ACCEPT.ALL.AUTHORS: "A 12.5Gb/s SerDes in 65nm CMOS Using a Baud- Rate ADC with Digital Receiver Equalization and Clock Recovery." ISSCC 2007 / SESSION 24 / MULTI-GB/S TRANSCEIVERS / 24, [Online] 14 February 2007 (2007-02-14), XP002483868 Retrieved from the Internet: URL:caesar.wont.accept.url> [retrieved on 2008-06-11]
- BEUKEMA, T.; SORNA, M.; SELANDER, K.; ZIER, S.; JI, B.L.; MURFET, P.; MASON, J.; RHEE, W.; AINSPAN, H.; PARKER, B.; BEAKES, M.;: "A 6.4-Gb/s CMOS SerDes core with feed-forward and decision-feedback equalization" SOLID-STATE CIRCUITS, IEEE JOURNAL OF, [Online] vol. 40, no. 12, December 2005 (2005-12), pages 2633-2645, XP002484180 Retrieved from the Internet: URL:http://ieeexplore.ieee.org/search/sear chresult.jsp?history=yes&queryText=%28%28c mos+serdes+core%29%3Cin%3Emetadata%29> [retrieved on 2008-06-11]

## Description

The present invention relates to the transmission of data between circuits.

At very high data rates the transmission of data even within integrated circuits can present challenges. These include dissipation of the signal and using the same clock signal to time parts of the circuit that are some distance from each other. This application relates to several approaches to those problems taking as an example a data transmission and reception circuit.

S. Kasturi & J.H. Winters, "Techniques for High-speed Implementation of Nonlinear Cancellation", IEEE Journal on Selected Areas in Communications, Vol. 9, No. 5, June 1991, pages 711-717, describes using multiple detectors with digital logic to eliminate analogue switch and propagation delay problems of nonlinear cancellation and decision feedback equalization.

The present invention provides a circuit as defined in the appended claims

Examples of the invention will now be described with reference to the accompanying drawings, of which:
FIGURE 1 is a block diagram a receiver circuit,
FIGURE 2 shows the feed forward equaliser and the decision feedback equaliser of the receiver circuit of Figure 1,
FIGURE 3 is a graph showing the post equalised signal amplitude for exemplary bit patterns,
FIGURE 4 is a diagram of a transmitter, with which the invention may be used,
FIGURE 5a shows the response of the receiver to a PRBS transmitted eye-pattern, and
FIGURE 5b shows the interleaved output of the ADCs of the receiver.
FIGURE 6 shows the transmitter and receiver circuits in more detail,
FIGURE 7 shows the connections of a multiplexer in the transmitter circuit,
FIGURE 8 shows two of the multiplexers in different transmitter lanes,
FIGURE 9 is a block diagram of the data marshalling circuit,
FIGURE 10 shows the data marshalling circuit set up to transmit at a lower rate,
FIGURE 11 shows the data output from the transmitter at that lower rate,
FIGRUE 12 is a diagram showing the data output by the multiplexer of the transmitter at the lower rate,
FIGURE 13 shows an alternative connection for the loopback channels at the receiver end,
FIGURES 14 and 15 each show an alternative connection for the loopback channels at the transmitter end.

A key challenge facing designers of high-bandwidth systems such as data-routers and super-computers is the requirement to transfer large amounts of data between ICs - either on the same circuit board or between boards. This data transmission application is called Serialisation-Deserialisation or "SerDes" for short. The present invention is useful in SerDes circuit and indeed was developed for that application. Nonetheless the invention may be used in other applications.

Analysis of typical backplane channel attenuation (which is around -24dB) and package losses (-1 to -2dB) in the presence of crosstalk predict that an un-equalized transceiver provides inadequate performance and that decision feedback equalization (DFE) is needed to achieve error rates of less than 10⁻¹⁷.

Traditional decision-feedback equalization (DFE) methods for SerDes receivers rely on either modifying, in analogue, the input signal based on the data history ["A 6.25Gb/s Binary Adaptive DFE with First Post-Cursor tap Cancellation for Serial backplane Communications" R Payne et al ISSCC 2005; "A 6.4Gb/s CMOS SerDes Core with feed-forward and Decision Feedback Equalization" M. Sorna et al ISSCC 2005*;* "A 4.8-6.4Gb/s serial Link for Backplane Applications Using Decision Feedback Equalization" Balan et al IEEE JSSC Nov 2005*.]* or on having an adaptive analogue slicing level ["Techniques for High-Speed implementation of Non-linear cancellation" S.Kasturia IEEE Journal on selected areas in Communications. June 1991*.]* (i.e. the signal level at which the circuit decides whether the signal represents a 1 or a 0).

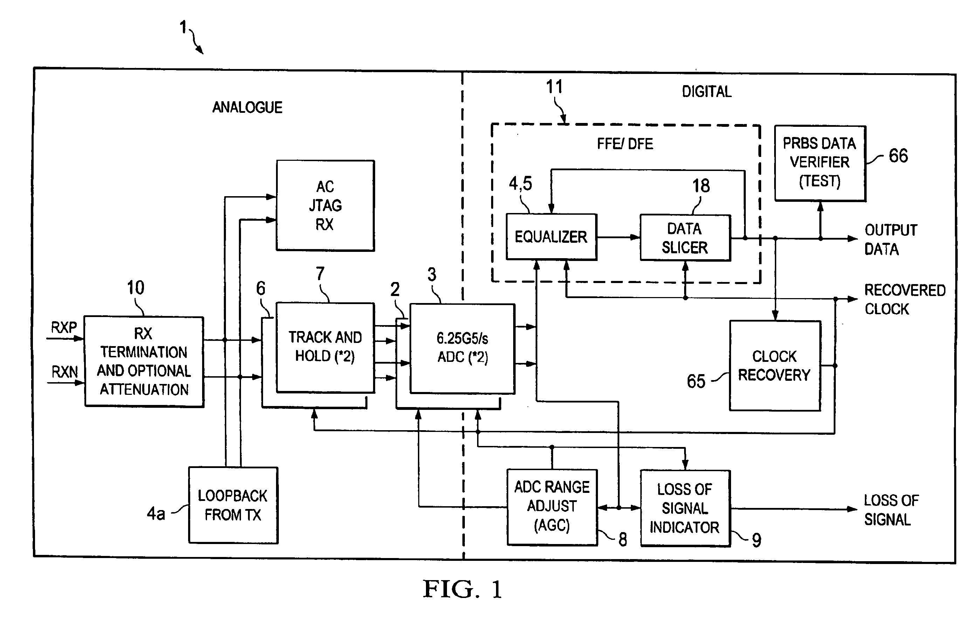

A block diagram of a SerDes receiver circuit 1, which forms part of an integrated circuit, in which the present invention may be used is shown in Figure 1. The invention may nonetheless be used in other applications.

In the receiver circuit 1 of Figure 1 the input data is sampled at the baud-rate, digitized and the equalization and clock & data recovery (CDR) performed using numerical digital processing techniques. This approach results in the superior power/area scaling with process of digital circuitry compared to that of analogue, simplifies production testing, allows straightforward integration of a feed-forward equalizer and provides a flexible design with a configurable number of filter taps in the decision feedback equaliser. The circuit has been implemented in 65nm CMOS, operating at a rate of 12.5Gb/s.

The receiver circuit 1 comprises two baud-rate sampling ADCs (analogue to digital converters) 2 and 3, a digital 2-tap FFE (feed forward equaliser) 4 and digital 5-tap DFE (decision feedback equaliser) 5 to correct channel impairments.

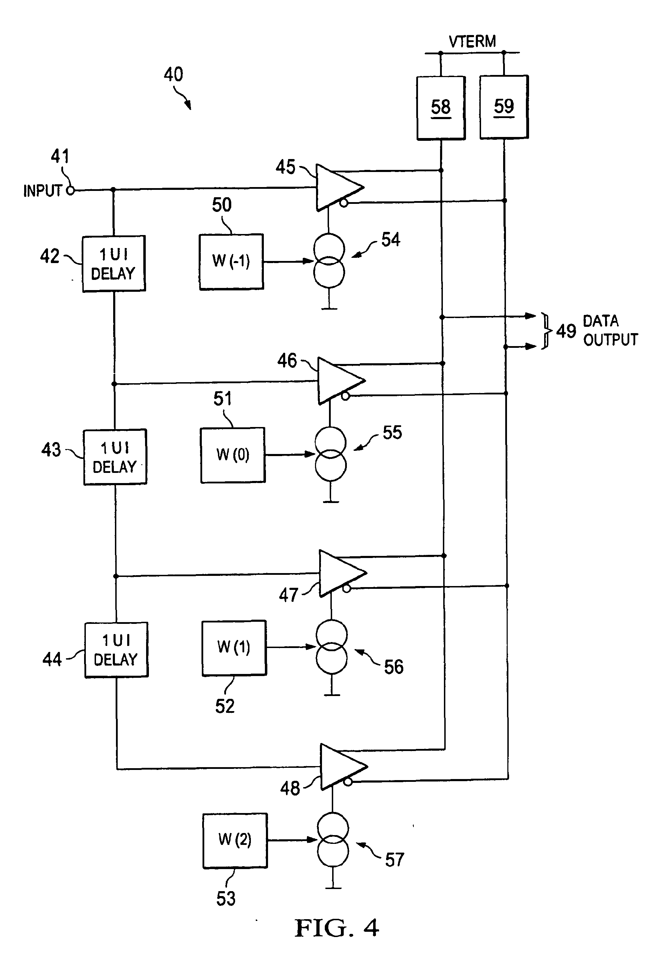

The SerDes section of the integrated circuit, which includes the receiver circuit 1 is also provided with a transmitter 40 (Figure 4), connected to transmit data over a parallel channel to that which the receiver circuit 1 is connected to receive data. The transmitter 40 comprises a 4-tap FIR filter to pre-compensate for channel impairments. In many applications the integrated circuit transmitting data to the receiver circuit 1 uses pre-compensation and in particular a similar transmitter circuit 40, but in other applications the receiver circuit 1 works without pre-compensation being used at the other end

The receiver 1 of Figure 1 is now described in more detail. The received data is digitized at the baud-rate, typically 1.0 to 12.5 Gb/s, using a pair of interleaved track and hold stages (T/H) 6 and 7 and a respective pair of 23 level (4.5 bit) full-flash ADCs 2 and 3 (i.e. they sample and convert alternate bits of the received analogue data waveform). The two track & hold circuits enable interleaving of the half-rate ADCs and reduce signal related aperture timing errors. The two ADCs, each running at 6.25 Gb/s for 12.5 Gb/s incoming data rate provide baud-rate quantization of the received data. The ADC's dynamic range is normalized to the full input amplitude using a 7-bit automatic gain control (AGC) circuit 8. A loss of signal indication is provided by loss of signal unit 9 that detects when the gain control signal provided by the AGC is out-of-range. An optional attenuator is included in the termination block 10, which receives the signals from the transmission channel, to enable reception of large signals whilst minimizing signal overload.

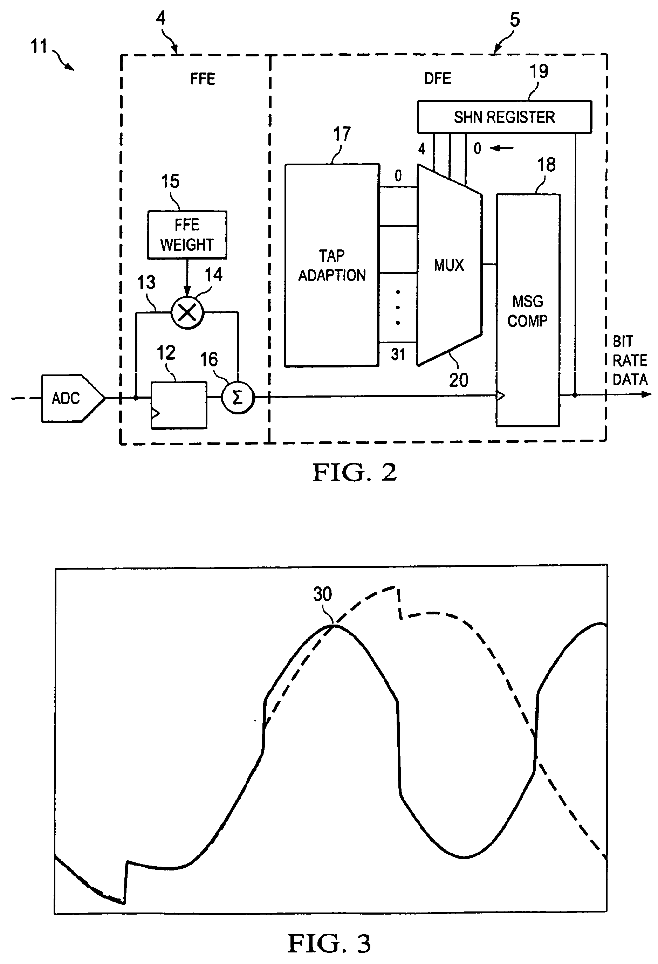

The digital samples output from the ADCs 2 and 3 are interleaved and the resulting stream of samples is fed into a custom digital signal processing (DSP) data-path that performs the numerical feed-forward equalization and decision-feedback equalization. This is shown in Figure 2. This comprises a 1 UI delay register 12 connected to receive the stream of samples from the ADCs 2 and 3. (1 UI is a period of the clock, i.e. the delay between bits.) A tap 13 also feeds the samples from the ADCs to a multiplier 14, each sample being received by the delay latch 12 and the multiplier 14 at the same time. The multiplier 14 multiplies each sample by a constant weight value (held in a programmable register 15), which value is typically 10%. The outputs of the multiplier 14 and the delay register 12 are added together by an adder 16 to provide the output of the FFE 4.

The digital FFE/DFE is implemented using standard 65nm library gates.

An advantage of applying the equalization digitally is that it is straightforward to include feed-forward equalization as a delay-and-add function without any noise-sensitive analogue delay elements. The FFE tap weight is selected before use to compensate for pre-cursor ISI and can be bypassed to reduce latency. Whilst many standards require pre-cursor de-emphasis at the transmitter, inclusion at the receiver allows improved bit error rate (BER) performance with existing legacy transmitters.

The DFE 5 uses an unrolled non-linear cancellation method ["Techniques for High-Speed implementation of Non-linear cancellation" S.Kasturia IEEE Journal on selected areas in Communications. June 1991]. The data output (i.e. the 1s and 0s originally transmitted) is the result of a magnitude comparison between the output of the FFE 4 and a slicer-level dynamically selected from a set stored in a set 17 of pre-programmed registers. The values are determined by a control circuit (not shown in Figure 1) from the waveforms of test patterns sent during a setup phase of operation. The magnitude comparison is performed by a magnitude comparator 18 connected to receive the output of the FFE 4 and the selected slicer-level; it outputs a 1 if the former is higher than the latter and a 0 if it is lower or equal, thereby forming the output of the DFE 5.

The slicer-level is selected from one of 2n possible options depending on the previous n bits of data history. The history of the bits produced by the magnitude comparator 18 is recorded by a shift register 19 which is connected to shift them in. The parallel output of the shift register is connected to the select input of a multiplexer 20 whose data inputs are connected to the outputs of respective ones of the set 17 of registers holding the possible slicer-levels.

Unrolled tap adaption is performed using a least mean square (LMS) method where the optimum slicing level is defined to be the average of the two possible symbol amplitudes (+/-1) when proceeded by identical history bits. (For symmetry the symbols on the channel for the bit values 1 and 0 are given the values +1 and -1).

Although 5-taps of DFE were chosen for this implementation, this parameter is easily scaleable and performance can be traded-off against power consumption and die area. In addition, the digital equalizer is testable using standard ATPG (automatic test pattern generation) and circular built-in-self-test approaches.

The chosen clock recovery approach uses a Muller-Mueller approach ["Timing recovery in Digital Synchronous Data Receivers" Mueller and Muller IEEE Transactions on Communications May 1976.] where the timing function adapts the T/H sample position to the point where the calculated pre-cursor inter-symbol interference (ISI) or h(-1) is zero, an example being given in Figure 3. The two curves show the post-equalized response for 010 and 011 data sequences respectively. The intersection 30 at 3440ps occurs when the sample of the second bit is independent of the third bit - that is, h(-1) = 0. This position can be detected by comparing the post-equalized symbol amplitude with the theoretical amplitude h(0) and using the difference to update the CDR's phase-interpolator.

A block diagram of the transmitter is shown in Figure 4, which is implemented using CML techniques. The data to be transmitted (received at terminal 41) is sequentially delayed by three 1 UI delay registers 42, 43 and 44 connected in series. They produce, via the four taps before and after each delay, a nibble-wide word containing the pre-cursor, cursor and two post-cursor components. In fact to ease timing closure the data is sent to the transmitter from the digital part of the circuit that supplies the data in blocks of 4 nibbles (16 bits in parallel), the blocks being sent at a rate of 3.125/s. Each nibble is a frame of four bits of the bitstream offset by one bit from the next so the nibbles overlap and represent the data redundantly. A multiplexer then selects one of the nibbles, switching between them at a rate of 12.5 x10⁹/s, and presents that in parallel to the four taps, thereby making the bitstream appear to advance along the taps.

A 4-tap FIR output waveform is obtained from simple current summing of the time-delayed contributions. This is done with differential amplifiers 45 to 48, each having its inputs connected to a respective one of the taps and having its differential output connected to a common differential output 49. Although shown as four differential amplifiers the circuit is implemented as one differential amplifier with four inputs, which minimizes return-loss. The relative amplitude of each contribution is weighted to allow the FIR coefficients to be optimized for a given circuit (e.g. a backplane) and minimize the overall residual ISI. The weights are determined empirically either for a typical example of a particular backplane or once a backplane is populated and are stored in registers 50 to 53. The weights respectively control the controllable driving current sources 54 to 57 of the differential amplifiers 45 to 48 to scale their output current accordingly. Respective pull-up resistors 58 and 59 are connected to the two terminals of the differential output 49.

A PLL is used to generate low-jitter reference clocks for the transmitter and receiver to meet standards["OIF-CEI-02.0 - Common Electrical I/O (CEI) - Electrical and Jitter Interoperability agreements for 6G+ bps and 11G+ bps I/O". Optical Internetworking Forum, Feb 2005*;* "IEEE Draft 802.3ap/Draft 3.0 - Amendment: Electrical Ethernet Operation over Electrical Backplanes" IEEE July 2006.]. Most integrated circuits will have more than one receiver 1 and the PLL is shared between them with each receiver having a phase interpolator to set the phase to that of incoming data.

The PLL uses a ring oscillator to produce four clock-phases at a quarter of the line data-rate. The lower speed clocks allow power efficient clock distribution using CMOS logic levels, but need duty-cycle and quadrature correction at the point of use. The 3.125GHz clocks are frequency doubled (XOR function) to provide the 6.25GHz clock for the T/H & ADC. The transmitter uses the four separate 3.125GHzphases, but they require accurate alignment to meet jitter specifications of 0.15UI p-p R.J. and 0.15UI p-p D.J.

The system described has been fabricated using a 65nm CMOS process and has been shown to provide error-free operation at 12.5Gb/s over short channels (two 11mm package traces, 30cmlow-loss PCB and two connectors). A legacy channel with -24dB of attenuation at 3.75 GHz supports error free operation at 7.5 Gb/s.

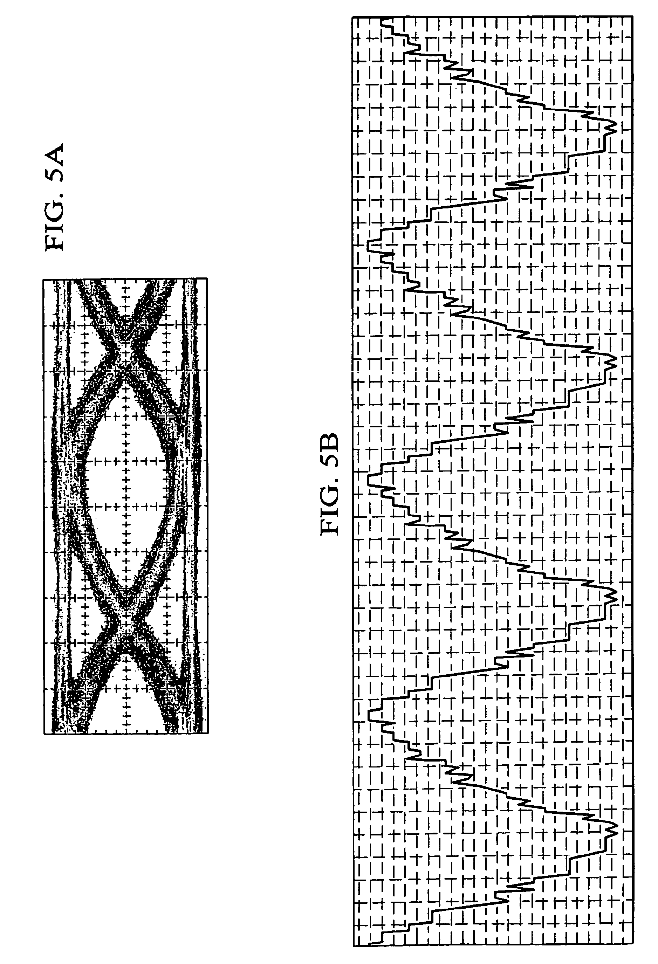

Figure 5a shows a 12.5 Gb/s 27-1 pseudo random bit stream (PRBS) transmitted eye-pattern with 20% de-emphasis on the first post-cursor. The receiver includes, for test purposes, a PRBS data verifier 66, which confirms that the test pattern has been received. The differential peak-to-peak (pp) amplitude is 700mV (200mV/div). Figure 5b shows the ADC output when a 6.25GHz sine-wave is sampled and the phase between the sine-wave and receiver is incremented using a programmable delay-line. The measured codes are within +/-1 lsb (least significant bit) of the expected values. This level of performance ensures robust operation over a wide range of cables, green-field and legacy channels. The worst-case power of a single TX/RX pair, or "lane" is 330mW and the total exemplary macro area is 0.45 mm² per lane (allowing for the PLL being shared by four TX/RX lanes.

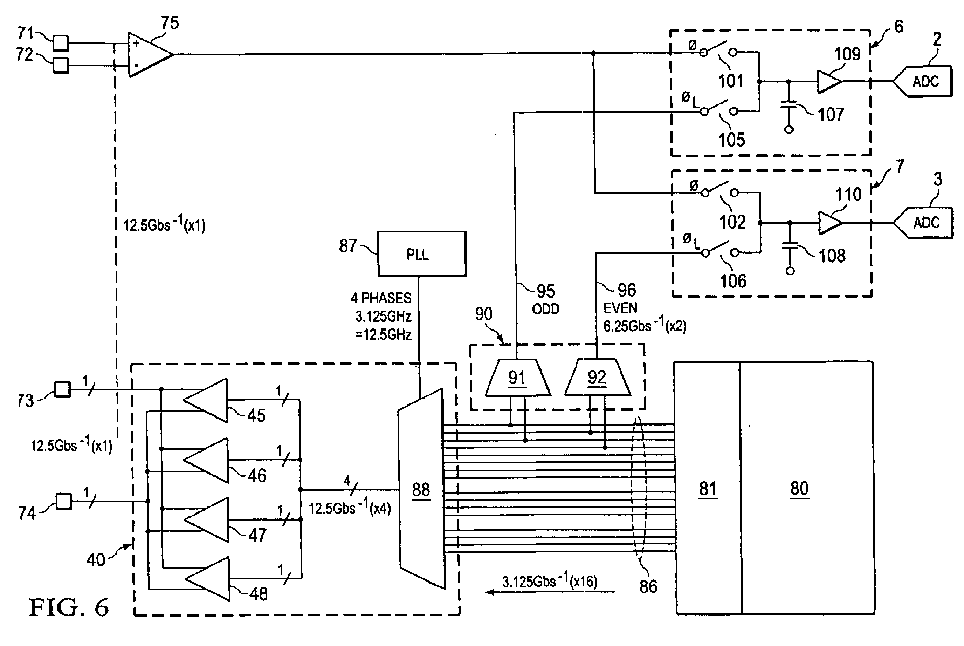

Figure 6 shows part of the receiver circuit 1 of Figure 2 and the transmitter circuit 40 of Figure 4 in more detail.

The transmitter 40 is shown at the bottom left of the Figure 6 connected to provide its pre-emphasised differential waveform. In fact this is final digital to analog converter and line driver stage of the transmitter. Digital parts 80 of the circuit that provide the data to be transmitted are in another location in the integrated circuit. A data marshalling circuit 81 takes the data from digital circuit 80 and presents on over a set of parallel conductors 86 (in this example sixteen in number), which link the digital and analog driver parts of the transmission side of the circuit, in the redundant manner that is described briefly above and in more detail below.

Transmitter 40 comprises, in this preferred example, the differential amplifiers (or combined differential amplifier) 45 to 48 mentioned above, having the programmable weights that are applied to their inputs applied to their respective inputs, which inputs are either 1 or 0. The weights are chosen to provide the desired pre-emphasis. The transmitter also has a multiplexer 88 which selects a group of four bits from four groups of four bits transmitted to the transmitter 40 over the sixteen conductors 86 by the data marshalling circuit 81. The select input to the multiplexer is connected to receive four phases of a 3.125 GHz clock from the PLL, which servers four transmitter / receiver lanes. The multiplexer is therefore cycled through the four groups at the rate of, in this example, 12.5GHz, giving the appearance of each data bit moving from input of the amplifiers 45 to 48 to the next each 1/(12.5 x 10⁹)s resulting in the data bits being transmitted from circuit (via differential pads 73 and 74) at a rate of 12.5Gbs⁻¹. This rate is referred to below, for reasons which will become clear, as the native rate of the transmitter.

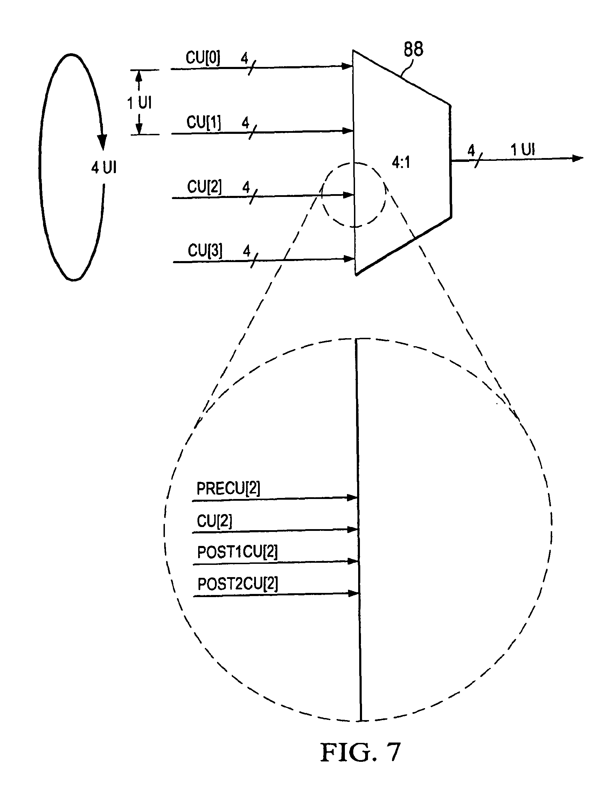

Figure 7 shows the multiplexer 88 and the patterns of the data it controls in more detail. The multiplexer receives on the conductors 86 four groups (each being labelled by one of their members CU[0] to CM[3] in the upper portion of the Figure) each group comprising four bits, with one group of four bits being shown in the lower portion. Each group comprises the cursor bit CU, which is the bit being transmitted, its precursor PRECU (the bit transmitted immediately before it) and its nearest two postcursor bits POST1CU and POST2CU. The weighted amplifier combines those bits to shape the waveform of the transmitted data with the desired per-emphasis in order to combat ISI.

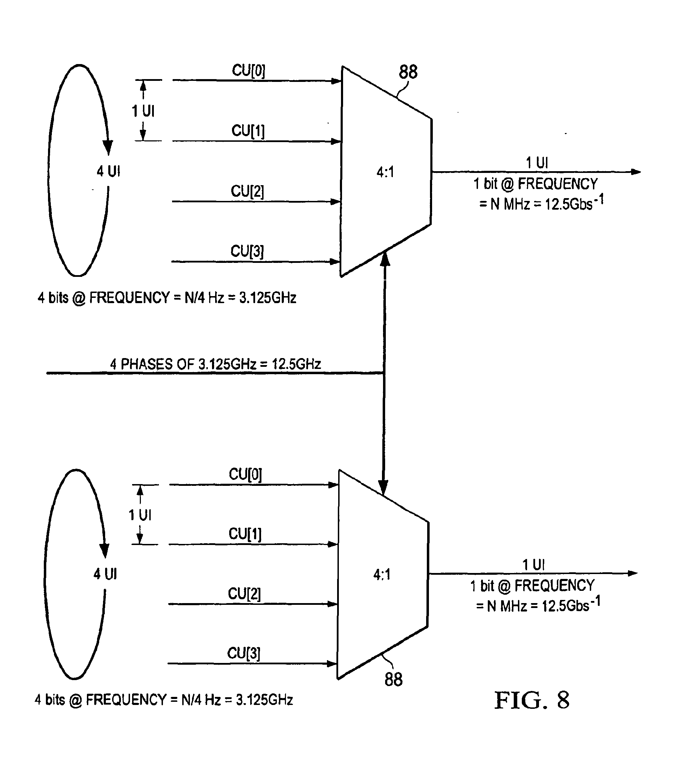

The bits on the conductors 86 are not independent but are redundant with PRECU[i+1] = CU[i], CU[i+1] = POST1CU[i], POST1CU [i+1] = PoST2CU[i] (the index being one unit of time UI). An advantage of this arrangement is that the data input to the multiplexer only changes at sub multiple of the data transmission rate of the output of the transmitter 40, in particular ¼ of the 12.5Gbs⁻¹ rate (=3.125Gbs⁻¹ on each of the conductors 86) since the multiplexer 99 is a 4:1 multiplexer. This relaxes the timing requirements as illustrated in Figure 8, which shows the multiplexers 88 of the transmitters 40 of two lanes (each transmitting their own datastream) timed by the same PLL 87. Here the same clock signal (12.5GHz - being 4 phases of 3.125GHz) is applied to cycle both multiplexers, which presents no timing difficulty, whereas using the idealised arrangement shown in Figure 4 of receiving the data into each transmitter on the single conductor 41 at the rate of 12.5 GBs⁻¹ and into the series of delay registers 42 to 44, also each clocked at the same rate, would be challenging since the time taken for the data and the clock signals would take to travel to those locations is significant at those frequencies.

In Figure 8 the two transmitter lanes are shown as transmitting at the same rate. As will become clear from a later example below, one or other or both can be arranged to transmit at a different rate without changing the frequency of the clock signals provided by the PLL 87.

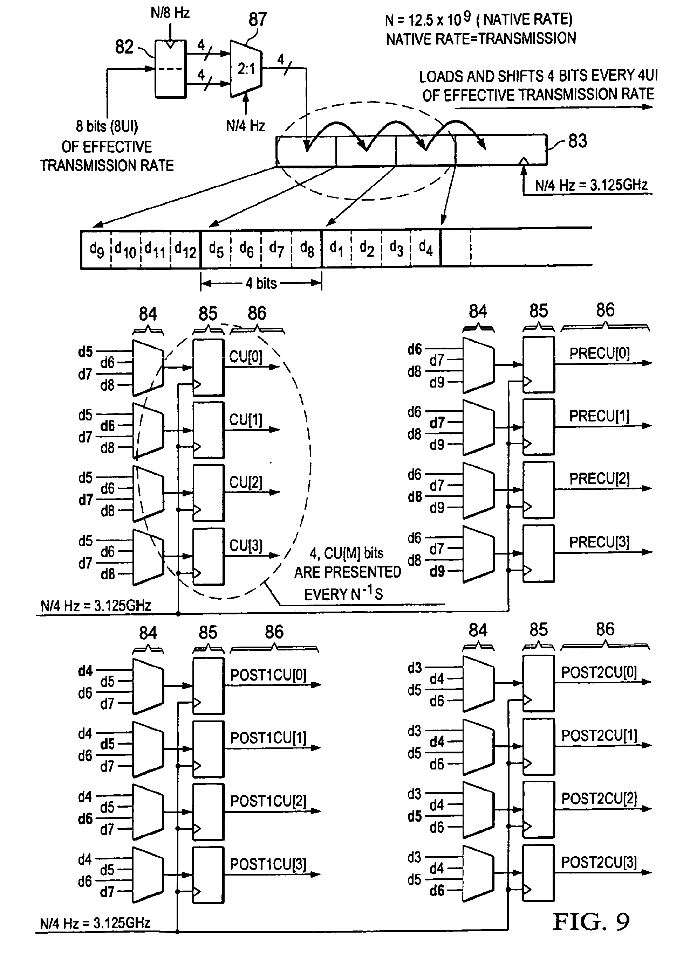

Figure 9 shows the components of the data marshalling circuit in the digital part 80 of the circuit, which takes the datastream to be transmitted and organises it in the redundant form on the conductors 86. The clock frequencies marked are for where the circuit is transmitting at the native rate of 12.5Gbs⁻¹. Register 82 receives the datastream in the form of 8 bit bytes in parallel, at a rate of 1 byte every 8/(12.5x10⁹)s. While each byte is in the register one of its component nibbles and then the other are selected in turn by a multiplexer 87 and loaded in parallel into a shift register 83. Each nibble is then moved along the shift register 4 places in one go every 4/(12.5x10⁹)s. (This is implemented with four one bit sift registers in parallel.) The bits held in the shift register 83 are output in parallel and are connected to the inputs of a plurality of speed selection mulitplexers 84. To avoid confusion in the Figure the conductors making those connections are not shown as lines but are indicated with the d-symbols used to mark the bits of the shift register and the inputs of the multiplexers to which they are connected. The output of each multiplexer is latched by a respective latch 85. This is clocked at a rate of 3.125GHz, i.e ¼ of the native rate of transmission from the transmitter circuit 40. The bit selected by each multiplexer is highlighted in bold in the Figure.

The selection made by each multiplexer 84 is controlled by a transmission speed select signal, which comprises 8 bits which are all distributed to each quadrant of the circuit of Figure 9, two bits for each multiplexer (since each is a 4:1 multiplexer) with the same two bits going to the top multiplexer in each group. The speed select signal does not change during the transmission of a bitstream but if it is desired to transmit at a different speed then that can be done by changing the value of this signal.

In the case of full native rate transmission speed as shown in Figure 9 the four groups of four bits transmitted to transmitter 40 on conductors 86 are therefore:
d6, d5, d4, d3 (on PRECU[0], CU[0], POST1CU[0], POST2CU[0]) ;
d7, d6, d5, d4 (on PRECU[1], CU[1], POST1CU[1], POST2CU[1]) ;
d8, d7, d6, d5 (on PRECU[2], CU[2], POST1CU[2], POST2CU[2]) ;
d9,d8,d7,d6 (on PRECU[3], CU[3], POST1CU[3], POST2CU[3]).

These are received by the multiplexer 88 in the transmitter 80, which selects those groups in that order. Once a cycle of that is completed the shift register 87 advances one nibble and a new set of bits is presented on conductors 86 through which multiplexer again cycles in groups of 4.

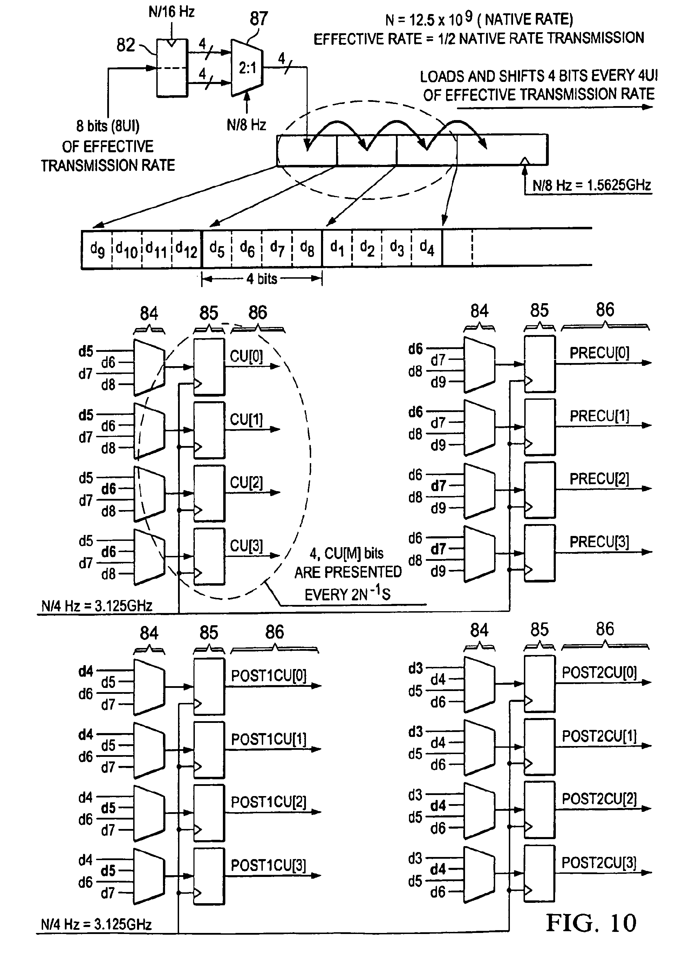

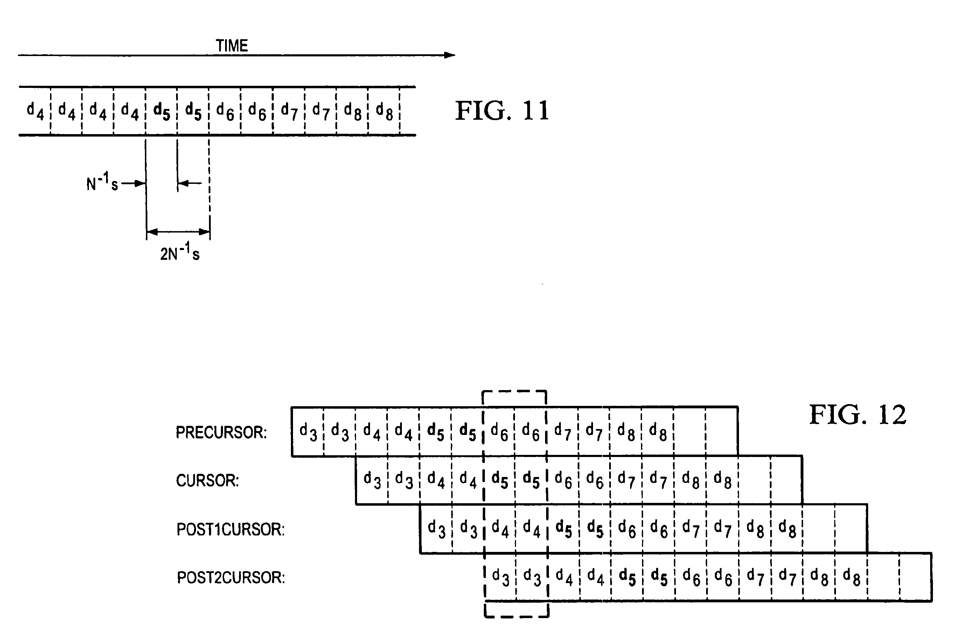

Figure 10 shows the same circuit as Figure 9 but with the transmission speed select signal set to cause the data to be transmitted from the transmission circuit at an effective rate of half the rate compared to the native rate set up in Figure 9. Figure 11 shows the result of the bits being output from transmitter 40 at the same native rate as before (in that latches 85 are again clocked at 3.125GHz and the multiplexer 88 again switches its selection of group of conductors 86 at the same rate of 12.5 GHz) but this time successive pairs of groups have the same bits. This is done by selecting with the multiplexers 84 each bit to be presented on a total of two of the conductors 86 with multiplexer 88 then selecting that bit value twice as it makes one cycle through the four groups of bits (i.e. the group of PRECU[0], CU[0], POST1CU[0], POST2CU[0] consists of the same data as that of the group of PRECU[1], CU[1], POST1CU[1], POST2CU[1], and the group of PRECU[2], CU[2], POST1CU[2], POST2CU[2] consists of the same data as that of the group of PRECU[3], CU[3], POST1CU[3], POST2CU[3]). There is, therefore, no change in the level output by transmitter 40 as multiplexer 88 switches from one member of such a pair of groups to the other, thereby effectively transmitting the data at half the native rate. The dotted box in Figure 12 shows the data output by multiplexer 88 during half of one of its cycles for this half rate transmission mode. Since the data is transmitted at half the rate the clock signals applied to register 82, multiplexer 87 and shift register 83 is each halved compared to Figure 9. However latches 84 are clocked at the same rate as before, namely 3.125 GHz.

A data rate of ¼ of that of Figure 9 is achieved by setting the transmission speed select signal by extending this spatial repetition of the data so that all four groups of conductors receive the same data (and reducing the clock rates applied to register 82, multiplexer 87 and shift register 83 by a factor of 4 compared to Figure 9).

A further reduction is clock rate to 1/8 of the full rate is achieved by leaving the transmission speed select signal the same as for the ¼ rate mode but, compared to that, halving the rates of the clocks applied to the register 82, multiplexer 87 and shift register 83. In this mode every other time latches 84 latch shift register 87 has not advanced and so the same data is presented again on the conductors 86. Multiplexer 86 therefore outputs the same group of bits for a total of two of its cycles (which proceed at the same rate as in the full native rate case).

An advantage of this arrangement is that accurate reconfigurable frequency dividers do not have to be provided in the transmitter 40 because the effective change of frequency is made in the digital part, i.e. data marshalling circuit 81.

If it is only desired to send data at one rate then of course the multiplexers 84 can be omitted and the connection of the relevant bits (those in bold) can be made directly to the inputs of the latches 85.

Similar arrangements having numbers of groups selected by the multiplexer 88 different from four can of course be provided. With 12 groups one could provide not only submultiples of the full rate frequency that are integer powers of two but at frequencies that are 1/3 and 1/6 of that.

Returning now to Figure 6, this Figure illustrates another aspect of the invention. Above there has been given details of the transmission side of the circuit. The Figure also shows the receiver side starting at differential input pads 71 and 72. The signals received here are amplified and referenced to circuit ground by an amplifier 75. The track and hold circuits 6 and 7 and analog to digital converts 2 and 3 are also shown (see also Figure 1). In transmitter receiver pairs sometimes a loopback path is provided linking the output pads to the input pads as is indicated by the dotted line so that test data can be sent via the transmitter directly to the receiver to provide a test of both without involving any circuit board tracks or cabling. This approach is not adopted in this aspect of the invention owing to the loss of signal that occurs at the very high data rates, such as 12.5Gbs⁻¹.

Instead there are provided two feedback channels 95 and 96 (each comprising a single conductor in this example). Loopback data is shared between these channels and is therefore transmitted at a lower rate; preferably the data is shared equally and so each operates at half the total rate. In this way the transmission and receiver halves of the circuit can be tested at full data rate but since the data rate on the loopback channels is halved the signal loss over the physical distance between the transmitter circuits and the receiver circuits is much reduced. If desired further loopback channels can be added to further reduce the data rate.

The receiver circuit of Figure 6 has two track and hold circuits 6 and 7 which operate alternately with their input respective input switches 101 and 102 closing alternately to sample alternately the level on the pads 71 and 72 onto respective capacitors 107 and 108, from where they are amplified by respective amplifiers 109 and 110 and presented to the inputs of respective ADCs 2 and 3. (The clock signals are supplied by the clock recovery circuit 65 in the receiver - see Figure 1.) In loopback mode those switches 101 and 102 are held open and two further switches 105 and 106 are held closed connecting the loopback channels 95 and 96 respectively to the sampling capacitors 107 and 108. This connection to the receiver circuit is advantageous because it isolates the loopback path from noise at the input pads 71 and 72. Accordingly such a connection will be useful even in cases where only a single loopback channel is being used.

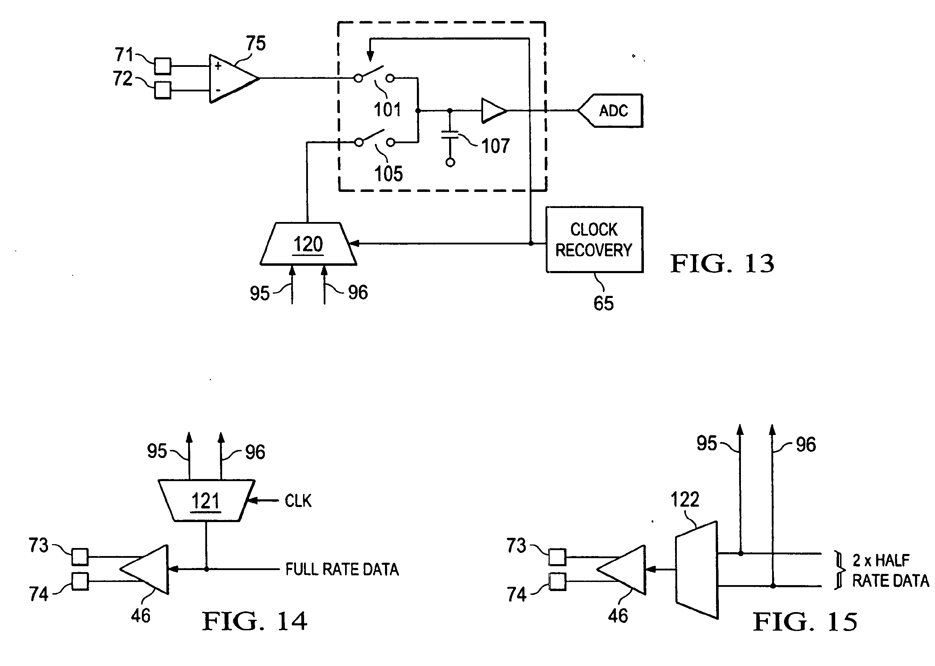

Having two input stages and two loopback channels is, of course, a convenience in this particular case. If there is only a single input stage then the data on the loopback channels can be multiplexed into a single stream once it has arrived at the receiver circuit just before it is applied to the input stage. This arrangement is shown in Figure 13 where multiplexer 120 is controlled by a clock signal again provided by the clock recovery circuit.

At the transmitter circuitry end of the loopback channels if the data is available at full rate it can be demultiplexed onto the loopback channels as shown in Figure 14 where a demultiplexer 121 is connected to receive the full rate data and divide it between the two loopback channels, the full rate data being transmitted in normal operation by amplifier 46 to pads 73 and 74. In Figure 6 this would correspond to picking up the data for loopback from the node between multiplexer 88 and amplifier 46. If the data is available in the transmitter side in two half rate streams these can be directly and respectively connected to the two loopback channels 95 and 96 as shown in Figure 15 (in normal operation multiplexer 122 combining them before transmission by amplifier 46). Figure 6 shows a further possibility in which the data is available at the transmitter side in four streams at an even lower rate than that to be used on the loopback streams, which is at the inputs to multiplexer 88. These could be used directly on four loopback channels in the manner of Figure 15 but in order not to take up to much space and because half rate provides acceptable levels of signal loss for each of the two loopback channels a respective multiplexer 91, 92 is provided to multiplex a respective pair of the streams of transmission data. (Note that all the data is available on four of the conductors 86, on which, as noted above, the data is represented in redundant form).

## Claims

1. A circuit comprising:
a plurality of groups of conductors (86, PRECU[0], CU[0], POST1CU[0], POST2CU[0] ... PRECU[3], CU[3], POST1CU[3], POST2CU[3]), each group being a plurality in number,
a first multiplexer (88) having the groups of conductors (86) connected to it as its inputs and having a select input to select one of the groups as its output, **characterized by**
a data marshalling circuit (81) arranged to provide, from a source (80), groups of bits (d6...d3, d7...d4, d8...d5, d9...d6) that are partially or fully overlapping with their neighbouring groups of bits, when the groups of bits are considered in a particular order, and to output each of those groups of bits on a respective one of, said groups of conductors (86), and
a select circuit arranged to provide the select input to cycle the multiplexer output through the groups of bits in said particular order.

2. A circuit as claimed in claim 1 wherein the data marshalling circuit (81) is arranged, or is arranged in one of its operating modes, to select neighbouring groups so their membership differs by the same number of member bits.

3. A circuit as claimed in claim 2 wherein the number of member bits by which groups differ is one.

4. A circuit as claimed in any preceding claim wherein data marshalling circuit (81) is arranged, or is arranged in at least one of its operating modes, to select a least one set of groups to have the same membership of bits.

5. A circuit as claimed in claim 4 wherein data marshalling circuit (81) is arranged, or is arranged in at least one of its operating modes, to select a least two sets of groups to have the same membership of bits, the two sets having different membership bits.

6. A circuit as claimed in claim 4 wherein the data marshalling circuit (81) is arranged, or is arranged in at least one of its operating modes, to supply to all the groups of conductors (86) the same set of bits.

7. A circuit as claimed in any preceding claim wherein the data marshalling circuit (81) comprises a register for holding the bits to be selected having outputs connected to supply the bits the said conductors (86).

8. A circuit as claimed in claim 7 wherein the register is a shift register (83).

9. A circuit as claimed in claim 8 wherein the shift register (83) moves forward the bits in the register by a plural number of places at each shift step.

10. A circuit as claimed in any of claim 7 to 10 comprising a plurality of multiplexers (84) connected to select between a plurality of the bits in the register (83) and to output that bit to a said conductor (86).

11. A circuit as claimed in any preceding claim comprising an output stage connected to receive the outputs of the first multiplexer (88) and to combine those into an output signal.

12. An integrated circuit comprising a circuit as claimed in any of claims 1 to 11.

13. An integrated circuit comprising a circuit as claimed in claim 11, wherein the output signal output from the output stage is connected to a terminal for connection outside the integrated circuit.

## Patentansprüche

1. Eine Schaltung bestehend aus:
einer Vielzahl von Sätzen von elektrischen Leitern (86, PRECU[0], CU[0], POST1CU[0], POST2CU[0]... PRECU[3], CU[3], POST1CU[3], POST2CU[3]), jeder Satz seiend eine Vielzahl in Anzahl,
einem ersten Multiplexer (88) habend die Leitersätze verbundet wie seine Eingabe damit, und habend eine Auswahleingabe, um einen der Sätze wie seine Ausgabe auszuwählen, **gekennzeichnet durch**
eine Datenordnungsschaltung (81) so konfiguriert, die von einer Quelle (80) Sätze von Bits (d6...d3, d7...d4, d8...d5, d9...d6) zu liefern, die teilweise oder vollig mit seiner angrenzenden Sätzen von Bits überlappen, wann die Sätze von Bits für eine bestimmte Ordnung gehaltet werden, und so konfiguriert jeder dieser Sätze von Bits auf einen jeweiligen einen der Sätze von Leitern (86) auszugeben, und
einer Auswahlschaltung so konfiguriert, die Auswahleingabe bereitzustellen, die die Multiplexerausgabe **durch** die Sätze von Bits in der bestimmten Ordnung in einem Zyklus auszuführen.

2. Eine Schaltung nach Anspruch 1, wobei die Datenordnungsschaltung (81) so konfiguriert ist, oder in einer seiner Betriebsarten so konfiguriert ist, die angrenzenden Sätze auszuwählen, damit ihre Zugehörigkeit sich durch die gleiche Anzahl von Zugehörigebits unterschiedet.

3. Eine Schaltung nach Anspruch 2, wobei die Anzahl von Zugehörigebits wodurch die Sätze sich unterschieden eins ist.

4. Eine Schaltung nach allen vorhergehenden Ansprüchen, wobei die Datenordnungschaltung (81) so konfiguriert ist, oder in einer seiner Betriebsarten so konfiguriert ist, mindestens eine Reihe von Sätzen auszuwählen, die die gleiche Zugehörigkeit von Bits haben.

5. Eine Schaltung nach Anspruch 4, wobei die Datenordnungsshaltung (81) so konfiguriert ist, oder in einer seiner Betriebsarten so konfiguriert ist, mindestens zwei Reihen von Sätzen auszuwählen, die gleiche Zugehörigkeit von Bits zu haben, die zwei Reihen habend unterschiedlicher Zugehörigkeitbits.

6. Eine Schaltung nach Anspruch 4, wobei die Datenordnungsshaltung (81) so konfiguriert ist, oder mindestens in einer seiner Betriebsarten so konfiguriert ist, zu allen Sätzen von Leitern (86) den gleichen Satz von Bits zu liefern.

7. Eine Schaltung nach allen vorhergehenden Ansprüchen, wobei die Datenordnungschaltung (81) aus einem Register für das Halten von Bits besteht, welche Bits ausgewählt werden werden und habend Ausgabe so verbundet, die jeweiligen Bits zu den Leitern (86) zu liefern.

8. Eine Schaltung nach Anspruch 7, wobei das Register ein Schieberegister (83) ist.

9. Eine Schaltung nach Anspruch 8, wobei die Bits in dem Register von einer Pluralanzahl von Stellen mit jedem Schiebeschritt bei dem Schieberegister (83) vorwärtsbewegt werden.

10. Eine Schaltung nach Ansprüchen 7 - 10 bestehend aus einer Vielzahl von Multiplexern (84) so verbundet, zwischen einer Vielzahl von Bits in dem Register (83) auszuwählen, und dieser Bit zu einem jeweilgen Leiter auszugeben.

11. Eine Schaltung nach allen vorhergehenden Ansprüchen bestehend aus einem Ausgabeschritt so verbundet, die Ausgaben von dem ersten Multiplexer (88) zu empfangen und diese Ausgaben in einem Ausgabesignal zu verbinden.

12. Eine integrierte Schaltung bestehend aus einer Schaltung nach Ansprüchen 1- 11.

13. Eine integrierte Schaltung bestehend aus einer Schaltung nach Anspruch 11, wobei das Ausgabesignal, das von dem Ausgabeschritt ausgegeben wird, zu einem Anschluss für die Verbindung ausserhalb der integrierten Schaltung verbundet wird.

## Revendications

1. Un circuit comprenant :
une pluralité d'ensembles de conducteurs (86, PRECU[0], CU[0], POST1CU[0], POST2CU[0]...PRECU[3]. CU[3], POST1CU[3], POST2CU[3]), chaque ensemble étant une pluralité en nombre,
un premier multiplexeur (88) auquel les ensembles de conducteurs (86) sont branchés comme ses entrées et ayant une entrée de sélection pour sélectionner un des ensembles comme sa sortie, **caractérisé par**
un circuit de marshall de données (81) configuré pour fournir, d'une source (80) les ensembles de bits (d6...d3, d7...d4, d8...d5, d9...d6) qui sont partiellement ou totalement chevauchant avec les ensembles de bits voisins, quand les ensembles de bits sont considérés dans un ordre spécifique, et pour sortir chacun de ces ensembles de bits sur un respectif desdits ensembles de conducteurs (86), et
un circuit de sélection configuré pour fournir l'entrée sélectionnée pour faire cycler la sortie du multiplexeur par les ensembles de bits dans ledit ordre spécifique.

2. Un circuit selon la revendication 1, où le circuit de marshall de données (81) est configuré, ou est configuré dans un de ses modes de fonction, pour sélectionner les ensembles voisins pour que leur adhésion diffère par le même nombre de bits adhérents.

3. Un circuit selon la revendication 2, où le nombre de bits adhérents par lequel les ensembles diffèrent est un.

4. Un circuit selon les revendications précédentes, où le circuit de marshall de données (81) est configuré, ou est configuré dans un de ses modes de fonction pour sélectionner au moins une série d'ensembles pour avoir la même adhésion de bits.

5. Un circuit selon la revendication 4, où le circuit de marshall de données (81) est configuré, ou est configuré dans un de ses modes de fonction pour sélectionner au moins deux séries d'ensembles pour avoir la même adhésion de bits, les deux séries ayant les bits d'adhérents différents.

6. Un circuit selon la revendication 4, où le circuit de marshall de données (81) est configuré, ou est configuré sans un de ses modes de fonction pour fournir tous les ensembles de conducteurs (86) avec la même série de bits.

7. Un circuit selon les revendications précédentes où le circuit de marshall de données (81) comprend un registre pour saisir les bits qui seront sélectionnés ayant les sorties branchées pour fournir les bits auxdits conducteurs (86).

8. Un circuit selon la revendication 7, où le registre est un registre à décalage (83).

9. Un circuit selon la revendication 8, où le registre à décalage (83) fait avancer les bits dans le registre par un nombre pluriel de places à chaque étape de décalage.

10. Un circuit selon les revendications 7 - 10 comprenant une pluralité de multiplexeurs (84) branchée pour sélectionner entre une pluralité des bits dans le registre (83) et pour sortir ce-bit-là audit conducteur (86).

11. Un circuit selon les revendications précédentes comprenant une étape de sortie branchée pour recevoir les sorties du premier multiplexeur (88) et pour les combiner à un signal de sortie.

12. Un circuit intégré comprenant un circuit selon les revendications 1 - 11.

13. Un circuit intégré comprenant un circuit selon la revendication 11, où le signal de sortie qui sort de l'étape de sortie est branché à un terminal pour le branchement au dehors du circuit intégré.
